# EUROPÄISCHE PATENTSCHRIFT

(11) **EP 3 878 008 B1**
(45) Veröffentlichungstag und Bekanntmachung des Hinweises auf die Patenterteilung: **12.03.2025**
(21) Anmeldenummer: 19794437.4
(22) Anmeldetag: 14.10.2019
(51) Int. Cl.: H01L 23/373, D03D 1/00, D03D 15/275, D03D 15/37, D03D 25/00, D04H 1/4242, D03D 27/10, H01L 23/473, H01L 23/42, D04H 1/4382

(54) **KÜHLKÖRPER MIT KOHLENSTOFFNANOSTRUKTURBASIERTEN FASERN**
HEAT SINK WITH CARBON-NANOSTRUCTURE-BASED FIBRES
DISSIPATEUR THERMIQUE COMPRENANT DES FIBRES À BASE DE NANOSTRUCTURES DE CARBONE

(30) Priorität: 05.11.2018 DE 102018218832
(43) Veröffentlichungstag der Anmeldung: 15.09.2021
(73) Patentinhaber: Robert Bosch GmbH, 70442 Stuttgart (DE)
(72) Erfinder: ARENZ, Christine, 70180 Stuttgart (DE); GROEGER, Ulrike, 70499 Stuttgart (DE); RAMSAYER, Reiner, 71277 Rutesheim (DE); BUTTICE, Giuseppe, 71665 Vaihingen/Enz (DE)
(86) Internationale Anmeldenummer: PCT/EP2019/077763
(87) Internationale Veröffentlichungsnummer: WO 2020/094340

(56) Entgegenhaltungen:
- EP-A1- 2 224 199
- EP-A1- 3 252 811
- EP-A2- 1 637 828
- EP-A2- 2 149 538
- EP-A2- 2 187 440
- JP-A- 2014 220 280
- US-A1- 2006 231 946
- US-A1- 2007 053 168
- US-A1- 2011 316 173
- US-A1- 2013 163 205

## Beschreibung

Die Erfindung betrifft einen Kühlkörper mit einem Grundkörper und mehreren kohlenstoffnanostrukturbasierten Fasern (CNB), insbesondere Kohlenstoff-Nano-Tubes beziehungsweise Kohlenstoff-Nano-Röhren (CNT) oder Graphenfasern, von denen zunächst einige am Grundkörper für einen Wärmeübergang befestigt sind.

### Stand der Technik

Aus der US 2007158584 ist ein Kühlkörper der eingangs genannten Art bekannt.

Der bekannte Kühlkörper besitzt einen Grundkörper, von dem kohlenstoffnanostrukturbasierte Fasern in paralleler Anordnung zueinander ausgehen. Der Kühlkörper dient der Kühlung eines mit dem Grundkörper verbundenen Gegenstands, wobei die kohlenstoffnanostrukturbasierten Fasern von einem Kühlmedium durchströmt werden. Die Wärme des Gegenstands gelangt daher zum Grundkörper, von dort zu den kohlenstoffnanostrukturbasierten Fasern und anschließend zum Kühlmedium.

JP2014-220280 A refers to a sheet-like structure used as heat radiation sheet for electronic apparatus, having a carbon nanotube element with linear structures, where a deformation of the first portion of the element is larger than that of the second portion of the element.

US2007/053168 A1 refers to a thermal management assembly, comprising a heat sink including a graphite layer obtained by cleaving a graphene layer from a graphite sheet, and a support layer.

US2013/163205 A1 refers to a heat-dissipation structure including a first carbon nanotube layer and a metal mesh layer. The first carbon nanotube layer and the metal mesh layer are stacked on each other. The first carbon nanotube layer includes at least one first carbon nanotube paper.

Derartige Kühlkörper können in der Elektrotechnik, insbesondere in der Leistungselektronik, eingesetzt werden, um beispielsweise die an Leistungshalbleitern entstehende Wärme abzuführen. Gerade auf dem Gebiet der Leistungselektronik, insbesondere bei aktuellen Invertern, sind Kühlkörper mit hoher Effizienz bei kleiner Bauform gefordert. Die Erfindung betrifft einen Kühlkörper, der bei einfacher Herstellung und kleiner Bauform dennoch eine Struktur mit sehr großer Oberfläche zur Verfügung stellt, sodass große Wärmemengen problemlos abgeführt werden können.

### Offenbarung der Erfindung

Der erfindungsgemäße Kühlkörper besitzt einen Grundkörper und mehrere kohlenstoffnanostrukturbasierte Fasern (CNB), insbesondere Kohlenstoff-Nano-Röhren (CNT) oder Graphenfasern, von denen zumindest einige am Grundkörper zur Wärmeabfuhr befestigt sind, wobei die Fasern aufgrund einer Haftung oder Abstützung untereinander ein Volumengefüge bilden, insbesondere in der Art von Watte, Filz oder eines Gespinsts, oder wobei die Fasern Schlaufen oder ein dreidimensionales Gewebe bilden. Des Weiteren ist mindestens eine Stützstruktur vorzusehen, insbesondere aus Metall und/oder vorzugsweise weiteren kohlenstoffnanostrukturbasierten Fasern (CNB), insbesondere Kohlenstoff-Nano-Röhren (CNT) oder Graphenfasern, die die Fasern abstützt. Bei der Stützstruktur handelt es sich demzufolge insbesondere um eine Metallstruktur oder um eine Faserstruktur, wobei diese Faserstruktur dann wiederum aus (insbesondere anderen) kohlenstoffnanostrukturbasierten Fasern beziehungsweise Kohlenstoff-Nano-Tubes, besteht. Die mindestens eine Stützstruktur ist gitterförmig ausgebildet und sie dient der Befestigung am Grundkörper und/oder dem Gegenkörper, wobei insbesondere vorgesehen sein kann, dass die Stützstruktur in den Grundkörper und/oder den Gegenkörper eingegossen ist.

Die Erfindung nutzt die spezifischen Eigenschaften von kohlenstoffnanostrukturbasierten Fasern (CNB), insbesondere Kohlenstoff-Nano-Tubes (CNT) oder Graphenfasern aus, die in einer sehr guten Wärmeleitfähigkeit besteht. Aufgrund des Volumengefüges der Fasern, der Schlaufen der Fasern oder des dreidimensionalen Gewebes wird eine sehr große Oberfläche geschaffen, sodass die Fasern sehr effektiv Wärme an ein vorzugsweise strömendes Kühlmedium abgeben können, wobei das Kühlmedium die Fasern umgibt oder durchströmt. Insbesondere kann es sich bei dem Kühlmedium um eine Kühlflüssigkeit handeln. Durch das Volumengefüge, bei dem sich die Fasern gegenseitig berühren, sodass eine Art Haftung oder Abstützung besteht, oder durch die Schlaufenstruktur der Fasern oder durch die Gewebestruktur des dreidimensionalen Gewebes wird nicht nur die erwähnte große Oberfläche geschaffen, sondern gleichzeitig ein relativ fester mechanischer Aufbau erzeugt, sodass auch ein strömendes Kühlmedium die Fasern nicht oder nur geringfügig verformt. Vielmehr wird aufgrund der erwähnten Strukturen eine sehr gute Verwirbelung der Strömung des Kühlmediums bewirkt, was zu einer besseren Wärmeableitung führt. Unter der erwähnten "Haftung" der Fasern untereinander ist grundsätzlich keine Verklebung oder dergleichen gemeint, sondern eine Art Reibwiderstand, der zum Beispiel zwischen zwei sich berührenden Fasern besteht. Gleichwohl ist - nach einer anderen Ausgestaltung - unter der erwähnten Haftung auch der Verbund zweier sich berührender Fasern zu verstehen, beispielsweise mittels einer zusätzlichen Substanz, wie beispielsweise eine Art Klebemittel oder dergleichen. Auch sind Lötstellen denkbar. Der Grundkörper steht wärmetechnisch mit einem zu kühlenden Gegenstand, vorzugsweise mindestens einem Leistungshalbleiter in Verbindung.

Nach einer Weiterbildung der Erfindung ist vorgesehen, dass die Fasern zumindest bereichsweise eine geordnete und/oder zumindest bereichsweise eine ungeordnete Struktur bilden. Im Falle eines watteartigen Volumengefüges liegt eine ungeordnete Struktur vor. Entsprechendes gilt für Filz oder für das Gespinst. Bei den schlaufenförmig verlaufenden Fasern ist eher von einer geordneten Struktur auszugehen. Gleiches gilt für das erwähnte Gewebe, da sich dort bestimmte Maschenmuster stets wiederholen.

Eine Weiterbildung der Erfindung sieht einen Gegenkörper vor, der mit Abstand zum Grundkörper liegt und an dem zumindest einige der Fasern befestigt sind. Durch die Befestigung von Fasern am Grundkörper und am Gegenkörper wird die gesamte Faserstruktur mechanisch besonders gut gehalten, sodass keine unerwünschten Verformungen durch ein strömendes Kühlmedium eintreten können. Das Kühlmedium strömt dann zwischen Grundkörper und Gegenkörper, sodass Wärme von den dazwischenliegenden Fasern abgeführt wird. Vorzugsweise kann auch der Gegenkörper Wärme abführen.

Vorzugsweise ist vorgesehen, dass die Befestigung am Grundkörper und/oder am Gegenkörper als Lötstellen, Klebestellen und/oder Eingießstellen ausgebildet ist. Grundkörper und/oder Gegenkörper können beispielsweise plattenartig gestaltet sein, wobei an diesen Platten die erwähnte Befestigung der Fasern erfolgt oder bei der Herstellung von Grundkörper und/oder Gegenkörper durch einen Gießvorgang Abschnitte der Fasern mit eingegossen werden.

Insbesondere kann vorgesehen sein, dass die Schlaufen Endbereiche aufweisen und dass zumindest einige der Endbereiche der Schlaufen an/in dem Grundkörper und/oder dem Gegenkörper befestigt sind. Bei den Endbereichen kann es sich um den Anfang und/oder das Ende einer Schlaufe handeln oder auch um einen Umkehrbereich der Schlaufe.

Vorzugsweise ist vorgesehen, dass die Fasern zumindest bereichsweise untereinander komprimiert sind. Bei der Herstellung wird beispielsweise eine watteartige Struktur der Fasern erzeugt und anschließend derart komprimiert, dass eine festere Struktur entsteht, wobei das Komprimieren jedoch nicht derart stark durchgeführt wird, dass sich Durchströmungswege für das Kühlmedium zu sehr schließen.

Um einen besonderen Widerstand gegen das strömende Kühlmedium zu schaffen, kann vorgesehen sein, zumindest einige der Fasern mit einer mechanisch stabilisierenden Beschichtung zu versehen.

Vorzugsweise ist vorgesehen, dass das dreidimensionale Gewebe durch die Art der Maschen des Gewebes und/oder die Maschenweite des Gewebes mechanisch stabilisiert ist. Auch durch diese sich aus den Maschen ergebende Stabilisierung werden die kohlenstoffnanostrukturbasierten Fasern, insbesondere Kohlenstoff-Nano-Tubes, mechanisch gegen Verformungen geschützt.

Es kann vorgesehen sein, dass zumindest einige der Fasern von einer insbesondere flächigen, von den Fasern und/oder weiteren kohlenstoffnanostrukturbasierten Fasern (CNB), insbesondere Kohlenstoff-Nano-Röhren (CNT) oder Graphenfasern, gebildeten Faserbasis ausgehen. Diese Faserbasis kann insbesondere an dem Grundkörper und/oder dem Gegenkörper befestigt sein beziehungsweise in den Grundkörper und/oder den Gegenkörper eingegossen sein.

Insbesondere ist es möglich, dass die erwähnte Faserbasis als Gewebe ausgebildet ist.

Eine Weiterbildung der Erfindung sieht vor, dass zumindest einige der Fasern von dem Grundkörper zu dem Gegenkörper unter einem Winkel ungleich von 90° zur Erzielung einer möglichst großen Faserlänge zwischen diesen beiden Körpern und/oder unter einem Winkel von 90° verlaufen. Je größer die Faserlänge zwischen Grundkörper und Gegenkörper ist, umso mehr Wärme kann die einzelne Faser abführen.

Die Erfindung wird in den nachstehenden Ansprüchen definiert.

Die Zeichnungen veranschaulichen die Erfindung anhand von Ausführungsbeispielen und zwar:
- Figur 1: einen Bereich eines Kühlkörpers mit schlaufenförmigen kohlenstoffnanostrukturbasierten Fasern,
- Figur 2: den Bereich des Kühlkörpers der Figur 1 mit einem Bereich eines Gegenkörpers,
- Figur 3: einen Bereich eines Kühlkörpers mit kohlenstoffnanostrukturbasierten Fasern in Form von Einzelfilamenten und in Form von Schlaufen,
- Figur 4: einen Bereich eines Kühlkörpers mit einer Faserbasis sowie kohlenstoffnanostrukturbasierten Fasern in Form eines Volumengefüges, zum Beispiel in der Art von Watte oder Filz oder eines Gespinsts,
- Figur 5: Bereiche zweier Varianten eines Kühlkörpers mit im Wesentlichen zur Faserbasis rechtwinklig oder zur Faserbasis schräg verlaufenden Filamenten und
- Figur 6: einen Bereich eines Kühlkörpers mit gitterförmigen Stützstrukturen sowie schlaufenförmig verlaufenden Fasern.

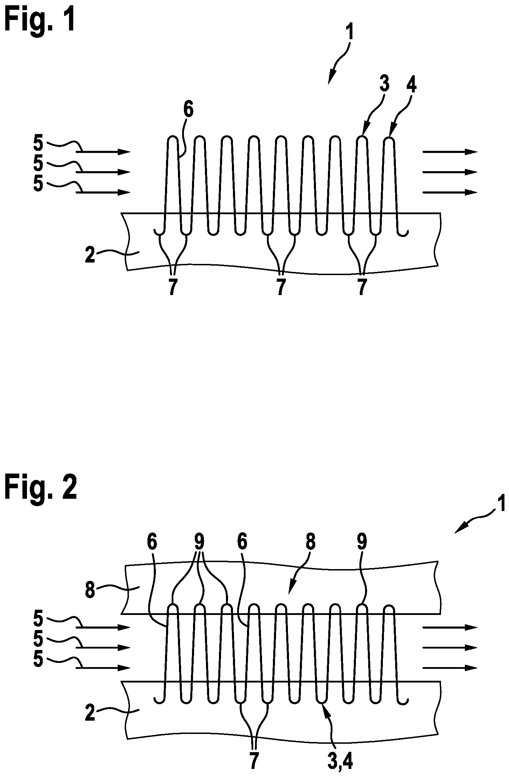

Die Figur 1 zeigt einen Kühlkörper 1, der einen Grundkörper 2 sowie kohlenstoffnanostrukturbasierte Fasern 3, insbesondere Kohlenstoff-Nano-Tubes 4, die auch als Kohlenstoff-Nano-Röhren oder -Röhrchen bezeichnet werden, oder alternativ Graphenfasern, aufweist. Mit dem Kühlkörper 1 ist ein Leistungselektronikbauteil wärmetechnisch verbunden(nicht dargestellt), das im Betrieb gekühlt werden muss. Ein mit Pfeilen 5 angedeutetes Kühlmedium, zum Beispiel eine Kühlflüssigkeit, strömt entlang des Kühlkörpers 1, insbesondere quer zum Verlauf der Kohlenstoff-Nano-Tubes 4. Wärme des Leistungselektronikbauteils geht auf den Grundkörper 2 über, wird von dort zu den Kohlenstoff-Nano-Tubes 4 geleitet und von dem Kühlmedium abgeführt. Die Kohlenstoff-Nano-Tubes 4 verlaufen als Schlaufen 6, die etwa eine mäanderförmige Struktur bilden, wobei Endbereiche 7 der Schlaufen 6 in den Grundkörper 2 eingebettet sind. Das Einbetten erfolgt vorzugsweise durch Eingießen beim Erstellen des Grundkörpers 2. Der Grundkörper 2 besteht vorzugsweise aus gut wärmeleitendem Material, insbesondere Metall. Durch die Schlaufenstruktur der Kohlenstoff-Nano-Tubes 4 weisen diese gegenüber dem strömenden Kühlmedium eine gute mechanische Stabilität auf, sodass sie nicht durch die Strömung deformiert werden. Ferner führt die Schlaufenform zu einem sehr guten Wärmeübergang, da eine große Oberfläche erzeugt ist.

Bei der Figur 2 und allen anderen, folgenden Figuren sind gleiche Bezugszeichen für gleiche Teile wie bei der Figur 1 verwendet, sodass nicht im Einzelnen wiederum eine Erläuterung erfolgen muss. Es gilt vielmehr Entsprechendes. Der Bereich des Kühlkörpers 1 der Figur 2 ist ebenso aufgebaut wie in der Figur 1, jedoch liegt zusätzlich dem Grundkörper 2 mit Abstand ein Gegenkörper 8 gegenüber, derart, dass Endbereiche 9 der Schlaufen 6 an diesem Gegenkörper 8 befestigt, vorzugsweise in diesen eingegossen sind. Hierdurch werden die Schlaufen 6 beidendig gehalten, wodurch eine noch bessere mechanische Stabilität gegeben ist. Die Befestigung der Kohlenstoff-Nano-Tubes 4 am Grundkörper 2 und/oder am Gegenkörper 8 kann auch auf andere Art und Weise erfolgen, beispielsweise in Form von Lötstellen oder Klebestellen.

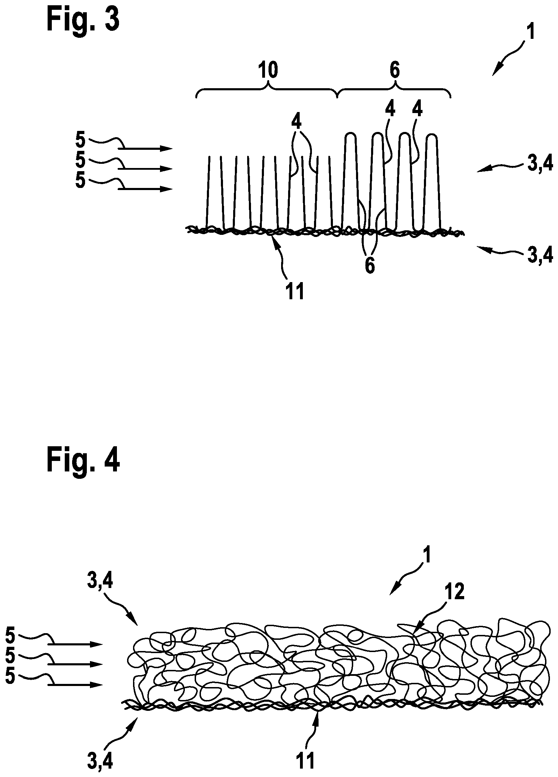

Die Figur 3 zeigt einen Bereich eines Kühlkörpers1, der sowohl Einzelfilamente 10 als auch Schlaufen 6 bezüglich der Kohlenstoff-Nano-Tubes 4 aufweist. Alternativ ist es auch möglich, dass ein Kühlkörper 1 vorliegt, der nur Einzelfilamente 10 oder nur Schlaufen 6 besitzt. Die Einzelfilamente 10 weisen jeweils eine Art stabförmige Ausbildung auf. Beim Ausführungsbeispiel der Figur 3 gehen die Kohlenstoff-Nano-Tubes 4 von einer Faserbasis 11 aus, die am Grundkörper 2 befestigt oder in diesen eingebettet ist (nicht dargestellt). Vorzugsweise bilden die Kohlenstoff-Nano-Tubes 4 sowohl die Faserbasis 11 als auch die Einzelfilamente 10 beziehungsweise die Schlaufen 6. Die Faserbasis 11 kann vorzugsweise in Form von verschlungenen oder verwebten Bereichen der Kohlenstoff-Nano-Tubes 4 gebildet werden.

Die Figur 4 zeigt einen Bereich eines Kühlkörpers 1, bei dem ebenfalls eine Faserbasis 11 vorliegt, die vorzugsweise als im Wesentlichen flächenförmiges Gewebe ausgebildet ist. Ebenso wie im Ausführungsbeispiel der Figur 3 ist die Faserbasis 11 in einen Grundkörper 2 eingebettet oder an diesem befestigt (nicht dargestellt). Der Kühlkörper 1 der Figur 4 weist ferner Kohlenstoff-Nanostrukturbasierte Fasern 3, insbesondere Kohlenstoff-Nano-Tubes 4 oder Graphenfasern auf, die in diesem Ausführungsbeispiel ein Volumengefüge 12 bilden, wobei die Fasern aufgrund einer Haftung oder Abstützung untereinander Kontakt haben, sodass insbesondere ein Volumengefüge 12 in Art von Watte, Filz oder eines Gespinsts vorliegt. Dieses Volumengefüge 12 führt zu einer sehr großen Oberfläche der Kohlenstoff-Nano-Tubes 4 und auch zu einem stabilen mechanischen Aufbau. Nach einem speziellen Ausführungsbeispiel kann vorgesehen sein, dass die kohlenstoffnanostrukturbasierten Fasern 3 zumindest bereichsweise untereinander komprimiert sind, um einen noch kompakteren und damit festeren Aufbau zu erzielen, der allerdings hinreichende Strömungswege für das Kühlmedium offen lässt.

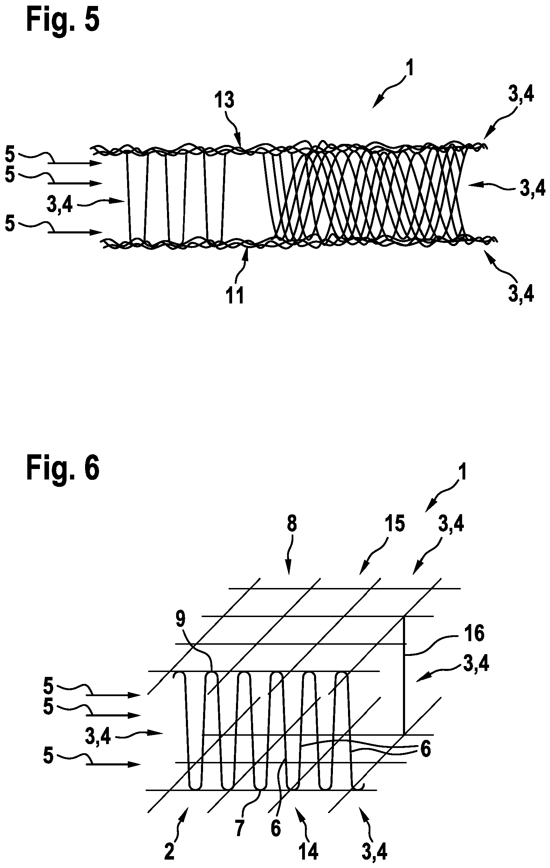

Beim Ausführungsbeispiel der Figur 5 ist auf der linken Seite ein Aufbau gezeigt, so wie er schon aus der linken Seite der Figur 3 hervorgeht, also ein Aufbau mit Einzelfilamenten 10, die vorzugsweise teilweise in die Faserbasis 11 eingearbeitet sind, dann jedoch mit "freien Bereichen" im Strömungsweg des Kühlmediums liegen, wobei der Unterschied der Figur 5 zur Figur 3 darin besteht, dass auch auf der gegenüberliegenden Seite zur Faserbasis 11 eine weitere Faserbasis 13 vorliegt, die von Endbereichen der kohlenstoffnanostrukturbasierten Fasern 3 gebildet ist, sodass insgesamt die freien Faserbereiche beidendig abgestützt sind und daher durch die Strömung des Kühlmediums nicht verformt werden. Auf der rechten Seite der Figur 5 ist ein entsprechendes Beispiel eines Kühlkörpers 1 gezeigt, so wie er aus der linken Seite der Figur 5 hervorgeht, wobei jedoch der Unterschied zwischen diesen beiden Varianten darin besteht, dass auf der linken Seite die freien Faserbereiche insbesondere senkrecht zur Strömung des Kühlmediums 5 stehen und damit im Wesentlichen rechtwinklig auf den beiden Faserbasen 11 beziehungsweise 13; auf der rechten Seite der Figur 5 verlaufen diese freien Faserbereiche jedoch schräg zur Strömung des Kühlmediums, also schließen mit der jeweiligen Faserbasis 11 beziehungsweise 13 einen Winkel ungleich 90° ein. Hierdurch ergibt sich auf der rechten Seite der Figur 5 eine längere freie Faserlänge gegenüber dem Ausführungsbeispiel der linken Seite, wodurch eine größere Oberfläche geschaffen ist, die im Strom des Kühlmediums liegt.

Die Figur 6 verdeutlicht ein Ausführungsbeispiel eines Bereichs eines Kühlkörpers 1, bei dem ebenfalls ein Grundkörper 2 und ein Gegenkörper 8 vorhanden ist, wobei diese beiden Bauteile jedoch nicht gezeigt sind, sondern es ist jeweils nur eine gitterartige Stützstruktur 14 beziehungsweise 15 dargestellt, wobei die Stützstrukturen 14,15 vorzugsweise aus kohlenstoffnanostrukturbasierten Fasern 3, insbesondere Kohlenstoff-Nano-Tubes 4, gebildet sein können. Diese beiden Stützstrukturen 14,15 sind am Grundkörper 2 und/oder Gegenkörper 8 befestigt oder dort eingegossen und nehmen Endbereiche 7 und 9 von sich dazwischen erstreckenden kohlenstoffnanostrukturbasierten Fasern 3, insbesondere Kohlenstoff-Nano-Tubes 4, auf. Die Stützstrukturen 14 und 15 wirken stabilisierend. Insbesondere verbessern sie die Befestigung oder das Eingießen. Untereinander können die beiden Stützgitter 14 und 15 auch verbunden sein. Dies erfolgt wird mittels entsprechenden Verbindungen 16, von denen in der Figur 6 lediglich eine beispielhaft gezeigt ist. Hierdurch werden die beiden Stützstrukturen 14 und 15 auf Abstand gehalten. Die beiden Stützstrukturen 14 und 15 können auch aus Metall bestehen, also Metallgitter sein.

Zu allen Ausführungsbeispielen ist noch zu erwähnen, dass dort oft nur eine kohlenstoffnanostrukturbasierte Faser 3 oder nur wenige kohlenstoffnanostrukturbasierte Fasern 3 dargestellt sind. Beim kompletten jeweiligen Kühlkörper 1 ist zur Erzielung einer großen Oberfläche selbstverständliche eine sehr große Anzahl von kohlenstoffnanostrukturbasierten Fasern 3 insbesondere in dreidimensionaler Anordnung vorgesehen.

Beim Ausführungsbeispiel der Figur 5 (sowohl links als auch rechts) besteht jeweils eine geordnete Struktur der kohlenstoffnanostrukturbasierten Fasern 3, die in diesem Falle im Wesentlichen parallel zueinander verlaufen. Beim Ausführungsbeispiel der Figur 4 liegt eine ganz andere Struktur vor, nämlich eine ungeordnete Struktur.

Über dies kann bei den verschiedenen Ausführungsbeispielen vorgesehen sein, dass zumindest einige der kohlenstoffnanostrukturbasierten Fasern 3 mit einer mechanisch stabilisierenden Beschichtung versehen sind. Auch dies führt dazu, dass die kohlenstoffnanostrukturbasierten Fasern 3 im Strom des gekühlten Mediums relativ stabil bleiben und sich nicht allzu sehr verbiegen. Beispielsweise kann eine Beschichtung aus Kupfer oder einem anderen Metall vorgesehen sein.

Insbesondere beim Ausführungsbeispiel der Figur 4 kann anstelle des Volumengefüges 12 in Form von Watte, Filz oder eines Gespinst auch vorgesehen sein, dass ein dreidimensionales Gewebe vorliegt, das heißt, das Volumengefüge 12 wird mit Hilfe von kohlenstoffnanostrukturbasierten Fasern 3 gewebt und dann zumindest einseitig in einen Grundkörper 2 eingebettet oder dort befestigt, wobei alternativ dies auch - sowie in Figur 4 dargestellt - mittels einer Faserbasis 11erfolgen kann, die vorzugsweise auch als gewebte Struktur aus kohlenstoffnanostrukturbasierten Fasern 3 erstellt ist.

## Patentansprüche

1. Kühlkörper (1) mit einem Grundkörper (2) und mehreren kohlenstoffnanostrukturbasierten Fasern (CNB, 3), insbesondere Kohlenstoff-Nano-Tubes (CNT, 4) oder Graphenfasern, von denen zumindest einige am Grundkörper (2) für einen Wärmeübergang befestigt sind, wobei die Fasern (3,4) aufgrund einer Haftung oder Abstützung untereinander ein Volumengefüge (12) bilden, insbesondere in der Art von Watte, Filz oder eines Gespinsts, oder wobei die Fasern (3,4) Schlaufen (6) oder ein dreidimensionales Gewebe bilden, **gekennzeichnet durch** mindestens eine Stützstruktur (14, 15), insbesondere aus Metall und/oder aus vorzugsweise weiteren kohlenstoffnanostrukturbasierten Fasern (CNB, 3), insbesondere Kohlenstoff-Nano-Tubes (CNT,4) oder Graphenfasern, die die Fasern (3, 4) stützt, wobei die mindestens eine Stützstruktur (14, 15) gitterförmig ausgebildet ist und der Befestigung am Grundkörper (2) und/oder Gegenkörper (8) dient, insbesondere in den Grundkörper (2) und/oder den Gegenkörper (8) eingegossen ist.

2. Kühlkörper nach Anspruch 1, **dadurch gekennzeichnet, dass** die Fasern (3, 4) zumindest bereichsweise eine geordnete und/oder zumindest bereichsweise eine ungeordnete Struktur bilden.

3. Kühlkörper nach einem der vorhergehenden Ansprüche, **gekennzeichnet durch** einen zu dem Grundkörper (2) mit Abstand liegenden Gegenkörper (8), an dem zumindest einige der Fasern (3,4) befestigt sind.

4. Kühlkörper nach einem der vorhergehenden Ansprüche, **dadurch gekennzeichnet, dass** die Befestigung am Grundkörper (2) und/oder am Gegenkörper (8) als Lötstellen, Klebestellen und/oder Eingießstellen ausgebildet ist.

5. Kühlkörper nach einem der vorhergehenden Ansprüche, **dadurch gekennzeichnet, dass** die Schlaufen (6) Endbereiche (7, 9) aufweisen und dass zumindest einige der Endbereiche (7, 9) der Schlaufen (6) an/in dem Grundkörper (2) und/oder dem Gegenkörper (8) befestigt sind.

6. Kühlkörper nach einem der vorhergehenden Ansprüche, **dadurch gekennzeichnet, dass** die Fasern (3, 4) zumindest bereichsweise untereinander komprimiert sind.

7. Kühlkörper nach einem der vorhergehenden Ansprüche, **dadurch gekennzeichnet, dass** zumindest einige der Fasern (3, 4) mit einer mechanisch stabilisierenden Beschichtung versehen sind.

8. Kühlkörper nach einem der vorhergehenden Ansprüche, **dadurch gekennzeichnet, dass** das dreidimensionale Gewebe durch die Art der Maschen des Gewebes und/oder die Maschenweite des Gewebes mechanisch stabilisiert ist.

9. Kühlkörper nach einem der vorhergehenden Ansprüche, **dadurch gekennzeichnet, dass** zumindest einige der Fasern (3, 4) von einer insbesondere flächigen von den Fasern (3, 4) und/oder weiteren kohlenstoffnanostrukturbasierten Fasern (CNB, 3), insbesondere Kohlenstoff-Nano-Tubes (CNT, 4) oder Graphenfasern, gebildeten Faserbasis (11, 13) ausgehen.

10. Kühlkörper nach einem der vorhergehenden Ansprüche, **dadurch gekennzeichnet, dass** die Faserbasis (11, 13) an/in dem Grundkörper (2) und/oder Gegenkörper (8) befestigt ist.

11. Kühlkörper nach einem der vorhergehenden Ansprüche, **dadurch gekennzeichnet, dass** die Faserbasis (11, 13) als Gewebe ausgebildet ist.

12. Kühlkörper nach einem der vorhergehenden Ansprüche, **dadurch gekennzeichnet, dass** zumindest einige der Fasern (3, 4) von dem Grundkörper (2) zu dem Gegenkörper (8) unter einem Winkel ungleich von 90 Grad zur Erzielung einer möglichst großen Faserlänge zwischen diesen beiden Körpern und/oder unter einem Winkel von 90 Grad verlaufen.

## Claims

1. Heat sink (1) having a main body (2) and a plurality of carbon nanostructure-based fibres (CNB, 3), in particular carbon nanotubes (CNT, 4) or graphene fibres, at least some of which are secured to the main body (2) for heat transfer, wherein due to mutual adhesion or support the fibres (3, 4) form a volume structure (12), in particular in the form of a wadding, felt or a yarn, or wherein the fibres (3, 4) form loops (6) or a three-dimensional fabric, **characterized by** at least one support structure (14, 15), in particular made of metal and/or of preferably further carbon nanostructure-based fibres (CNB, 3), in particular carbon nanotubes (CNT, 4) or graphene fibres, which supports the fibres (3, 4), wherein the at least one support structure (14, 15) is grid-shaped and assists the securing to the main body (2) and/or counterbody (8), in particular is cast into the main body (2) and/or the counterbody (8).

2. Heat sink according to Claim 1, **characterized in that** the fibres (3, 4) at least in regions form an ordered structure and/or at least in regions form an unordered structure.

3. Heat sink according to any of the preceding claims, **characterized by** a counterbody (8) which is a distance away from the main body (2) and has at least some of the fibres (3, 4) secured to it.

4. Heat sink according to any of the preceding claims, **characterized in that** the securing to the main body (2) and/or to the counterbody (8) is in the form of soldering sites, adhesive bonding sites and/or casting sites.

5. Heat sink according to any of the preceding claims, **characterized in that** the loops (6) comprise end regions (7, 9) and **in that** at least some of the end regions (7, 9) of the loops (6) are secured to/in the main body (2) and/or the counterbody (8).

6. Heat sink according to any of the preceding claims, **characterized in that** the fibres (3, 4) are at least in regions compressed with one another.

7. Heat sink according to any of the preceding claims, **characterized in that** at least some of the fibres (3, 4) are provided with a mechanically stabilizing coating.

8. Heat sink according to any of the preceding claims, **characterized in that** the three-dimensional fabric is mechanically stabilized by the type of mesh of the fabric and/or the mesh size of the fabric.

9. Heat sink according to any one of the preceding claims, **characterized in that** at least some of the fibres (3, 4) extend from an especially sheetlike fibre basis (11, 13) formed by the fibres (3, 4) and/or further carbon nanostructure-based fibres (CNB, 3), in particular carbon nanotubes (CNT, 4) or graphene fibres.

10. Heat sink according to any of the preceding claims, **characterized in that** the fibre basis (11, 13) is secured to/in the main body (2) and/or counterbody (8).

11. Heat sink according to any of the preceding claims, **characterized in that** the fibre basis (11, 13) is in the form of a fabric.

12. Heat sink according to any of the preceding claims, **characterized in that** at least some of the fibres (3, 4) extend from the main body (2) to the counterbody (8) at an angle not equal to 90 degrees to achieve the greatest possible fibre length between these two bodies and/or at an angle of 90 degrees.

## Revendications

1. Dissipateur thermique (1) avec un corps de base (2) et plusieurs fibres à base de nanostructures de carbone (CNB, 3), notamment des nanotubes de carbone (CNT, 4) ou des fibres de graphène, dont au moins certaines sont fixées au corps de base (2) pour un transfert de chaleur, les fibres (3, 4) formant une structure volumique (12) en raison d'une adhérence ou d'un soutien entre elles, notamment de type ouate, feutre ou toile, ou les fibres (3, 4) formant des boucles (6) ou un tissu tridimensionnel, **caractérisé par** au moins une structure de soutien (14, 15), notamment en métal et/ou de préférence en d'autres fibres à base de nanostructures de carbone (CNB, 3), notamment des nanotubes de carbone (CNT, 4) ou des fibres de graphène, qui soutient les fibres (3, 4), l'au moins une structure de soutien (14, 15) étant réalisée en forme de grille et servant à la fixation au corps de base (2) et/ou au contre-corps (8), notamment étant coulée dans le corps de base (2) et/ou le contre-corps (8).

2. Dissipateur thermique selon la revendication 1, **caractérisé en ce que** les fibres (3, 4) forment au moins par zones une structure ordonnée et/ou au moins par zones une structure désordonnée.

3. Dissipateur thermique selon l'une quelconque des revendications précédentes, **caractérisé par** un contre-corps (8) situé à distance du corps de base (2), sur lequel sont fixées au moins certaines des fibres (3, 4).

4. Dissipateur thermique selon l'une quelconque des revendications précédentes, **caractérisé en ce que** la fixation au corps de base (2) et/ou au contre-corps (8) est réalisée sous forme de points de brasage, de points de collage et/ou de points de coulée.

5. Dissipateur thermique selon l'une quelconque des revendications précédentes, **caractérisé en ce que** les boucles (6) présentent des zones d'extrémité (7, 9) et **en ce qu'**au moins certaines des zones d'extrémité (7, 9) des boucles (6) sont fixées sur/dans le corps de base (2) et/ou le contre-corps (8).

6. Dissipateur thermique selon l'une quelconque des revendications précédentes, **caractérisé en ce que** les fibres (3, 4) sont comprimées entre elles au moins par zones.

7. Dissipateur thermique selon l'une quelconque des revendications précédentes, **caractérisé en ce qu'**au moins certaines des fibres (3, 4) sont pourvues d'un revêtement stabilisant mécaniquement.

8. Dissipateur thermique selon l'une quelconque des revendications précédentes, **caractérisé en ce que** le tissu tridimensionnel est stabilisé mécaniquement par le type de mailles du tissu et/ou la taille des mailles du tissu.

9. Dissipateur thermique selon l'une quelconque des revendications précédentes, **caractérisé en ce qu'**au moins certaines des fibres (3, 4) partent d'une base fibreuse (11, 13), notamment plane, formée par les fibres (3, 4) et/ou d'autres fibres à base de nanostructures de carbone (CNB, 3), notamment des nanotubes de carbone (CNT, 4) ou des fibres de graphène.

10. Dissipateur thermique selon l'une quelconque des revendications précédentes, **caractérisé en ce que** la base fibreuse (11, 13) est fixée sur/dans le corps de base (2) et/ou le contre-corps (8).

11. Dissipateur thermique selon l'une quelconque des revendications précédentes, **caractérisé en ce que** la base fibreuse (11, 13) est réalisée sous forme de tissu.

12. Dissipateur thermique selon l'une quelconque des revendications précédentes, **caractérisé en ce qu'**au moins certaines des fibres (3, 4) s'étendent du corps de base (2) au contre-corps (8) selon un angle différent de 90 degrés pour obtenir une plus grande longueur de fibres possible entre ces deux corps et/ou selon un angle de 90 degrés.
